# DEMANDE DE BREVET EUROPEEN

(11) **EP 0 555 132 A1**
(43) Date de publication de la demande: **11.08.1993**
(21) Numéro de dépôt: 93400239.5
(22) Date de dépôt: 01.02.1993
(51) Int. Cl.: H04B 1/26

(54) **Récepteur superhétérodyne large bande**

(30) Priorité: 05.02.1992 FR 9201277
(71) Demandeur: ALCATEL TELSPACE, F-92734 Nanterre Cédex (FR)
(72) Inventeur: Leclerc, Gerard, F-95520 Osny (FR); Doncker, Jacques, F-95450 Vigny (FR)
(74) Mandataire: Pothet, Jean Rémy Emile Ludovic

(57) **Abrégé**

. Un récepteur superhétérodyne s'applique aux installations de réception de signaux de télévision transmis par satellite. Le récepteur permet la réception de tels signaux dans une bande RF élargie se situant par exemple entre 950 et 2750 MHz en transposant cette bande RF à fréquence intermédiaire fixe. Il comprend un filtre passe-bande (31) accordable dans la totalité de la bande de réception, un oscillateur local (40), et un moyen (41) commandant. le filtre passe-bande et l'oscillateur local pour établir un battement de fréquence entre la fréquence de l'oscillateur local et la fréquence d'accord du filtre passe-bande, ce battement correspondant à la fréquence FI. Le moyen de commande (41) est agencé pour que le battement de fréquence change de sens à partir d'une certaine fréquence d'accord du filtre de sorte que la bande balayée par l'oscillateur peut être moitié moins grande que la bande de réception.

## Description

L'invention concerne un récepteur superhétérodyne qui permet de recevoir des signaux dans une bande de fréquence élargie, cette bande de réception pouvant avoir une largeur très supérieure à 1GHz. Elle s'applique en particulier aux installations de réception de signaux transmis dans la bande satellite KU dont la largeur est d'environ 2 GHz. Cette bande KU s'étend aujourd'hui entre 10,950 GHz et 12,750 GHz.

Actuellement, pour recevoir dans la totalité de la bande satellite, un récepteur doit être relié à une antenne parabolique équipée de plusieurs convertisseurs dits faible bruit qui amène des sous-bandes de.la bande KU dans au moins une bande RF se situant entre 950MHz et 1750MHz. Cette bande RF a donc une largeur inférieure à 1 GHz. Pour recevoir dans la totalité de la bande KU, les convertisseurs doivent être commutés à tour de rôle en fonction de la sous-bande KU explorée ce qui rend compliquée l'utilisation de l'ensemble de réception. Un récepteur classique utilisé pour recevoir dans cette bande de réception RF comprend un filtre passe-bande accordable dans la totalité de la bande de réception RF, un oscillateur local balayant une bande de fréquence décalée par rapport à la bande de réception, et un moyen de commande asservissant le filtre passe-bande et l'oscillateur local pour établir un battement de fréquence entre la fréquence de l'oscillateur local et la fréquence d'accord du filtre passe-bande. Ce battement correspond à une fréquence intermédiaire fixe FI. La largeur de la bande de fréquence balayée par l'oscillateur est en général égale à la largeur de la bande de réception.

Il est envisagé aujourd'hui de transposer directement la bande KU à une bande RF se situant par exemple entre 950MHz et 2750MHz ou entre 700MHz et 2750MHz, ces bandes de fréquences étant dites élargies puisque leur largeur dépasse 1,8 GHz. La couverture de telles bandes de réception nécessiterait l'utilisation d'un oscillateur local balayant une bande de fréquence dont la largeur est au moins égale à 1,8 GHz. Un oscillateur de ce type est très couteux, difficilement réalisable et en tout cas inadapté au domaine de la radiodiffusion grand public.

On connaît de US-A-2460900 un récepteur superhétérodyne à fréquence intermédiaire capable de recevoir dans une bande élargie située entre 1052,5MHz et 1112,5MHz.

Le but de l'invention est d'améliorer un tel récepteur superhétérodyne pour recevoir dans des bandes de fréquence dites élargies et qui fait appel à un oscillateur local balayant une bande de fréquence dont la largeur est plus petite que celle de la bande de.réception, notamment une bande de fréquence de largeur inférieure à 1,1 GHz. Des oscillateurs couvrant une bande de fréquence de largeur inférieure à 1,1 GHz sont facilement réalisable et peu coûteux.

A cet effet l'invention a pour objet un récepteur superhétérodyne large bande à fréquence intermédiaire fixe, notamment pour installation de réception de signaux transmis par satellite, caractérisé en ce qu'il comprend:
- un filtre passe-bande accordable dans la totalité d'une bande de réception de largeur L;
- un oscillateur local balayant une bande de fréquences de largeur inférieure à la largeur L de la bande réception et centrée par rapport à celle-ci;
- un moyen de commande asservissant le filtre passe-bande et l'oscillateur local pour établir un battement de fréquences entre la fréquence d'accord du filtre passe-bande et la fréquence de l'oscillateur local, ce battement correspondant à la fréquence intermédiaire fixe FI égale au quart de la largeur de la bande de réception, le moyen de commande étant en outre agencé pour maintenir, en fonction d'un signal de commande représentatif d'une fréquence canal d'entrée à recevoir, la fréquence de l'oscillateur local au-dessus de la fréquence d'accord du filtre quand cette fréquence canal se situe dans une partie inférieure de la bande de réception et pour maintenir la fréquence de l'oscillateur local au-dessous de la fréquence d'accord du filtre quand cette fréquence canal se situe dans une partie supérieure de la bande de réception.

Dans ce cas, si L'est la largeur de la bande de fréquence couverte par l'oscillateur local, L'est égale au plus à L - 2FI. Ainsi, pour une bande de réception RF situant par exemple entre 950MHz et 2750MHz et pour une fréquence intermédiaire de 450MHz, la bande de fréquence couverte par l'oscillateur local se situera entre 1400MHz et 2300MHz.

Du fait que la fréquence intermédiaire FI est égale au quart de la largeur de la bande de réception, la bande de réception peut être explorée dans sa totalité de façon continue par le filtre accordable, c'est à dire sans coupure ni chevauchement de celle-ci.

D'autres caractéristiques et avantages de l'invention apparaîtront encore mieux à la lecture de la description détaillée qui suit d'un exemple de réalisation faite en référence aux dessins.

La figure 1 représente schématiquement un récepteur superhétérodyne selon l'invention.

La figure 2 illustre le battement de fréquence et son inversion de sens.

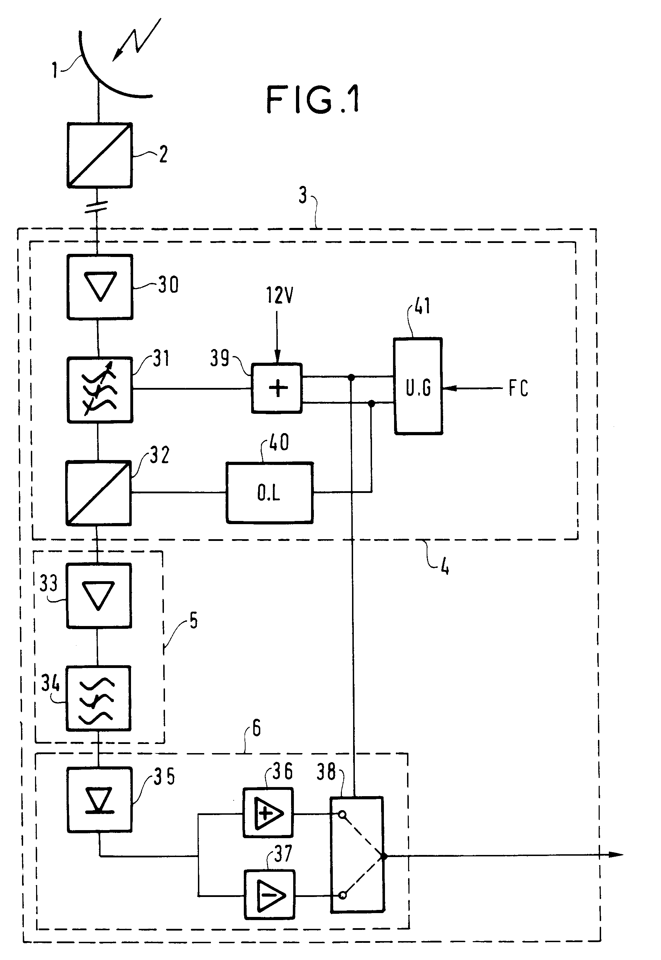

Sur la figure 1, le récepteur superhétérodyne 3 est montré couplé à un monoconvertisseur 2 faible bruit qui amène la bande d'entrée de l'antenne 1, par exemple la bande KU, dans la bande de réception RF du récepteur. L'antenne 1 peut être une antenne parabolique et la bande d'entrée peut se situer entre 10,700 GHz et 12,750 GHz. Le monoconvertisseur 2 amène cette bande d'entrée KU dans la bande RF de largeur L, par transposition directe à 10 GHz. La bande RF peut se situer entre 700 MHz et 2750 MHz ou entre 950 MHz et 2750 MHz.

Le récepteur 3 proprement dit est constitué d'un étage d'entrée accordable 4, d'un étage de filtrage à fréquence intermédiaire fixe 5, et d'un étage de démodulation 6 restituant des signaux en bande de base. Ces signaux peuvent être des signaux vidéo et son ou des données numériques puisque le récepteur peut être utilisé dans une application telle que TVRO (Television Reception Only), DATARO (Data Reception Only) ou autre.

L'étage d'entrée accordable comprend un préamplificateur 30 classique en soi dont l'entrée est couplée à la sortie du monoconvertisseur 2, un filtre passe-bande 31 accordable dans la totalité de la bande de réception sur une fréquence canal d'entrée, un oscillateur local 40, une unité de gestion 41 asservissant le filtre passe-bande et l'oscillateur local pour établir un battement de fréquence entre la fréquence de l'oscillateur local et la fréquence d'accord du filtre passe-bande de manière que ce battement correspond toujours à une fréquence intermédiaire unique et fixe FI. La fréquence d'accord du filtre 31 correspond à la fréquence canal d'entrée. La sortie du filtre 31 et la sortie de l'oscillateur 40 sont appliquées en entrée d'un mélangeur 32 classique en soi qui fournit des signaux de mélange.

Selon l'aspect essentiel de l'invention, L'oscillateur 40 balaie une bande de fréquence moins large que la bande de réception et centrée dans celle celle-ci. Par ailleurs, l'unité de gestion 41, qui reçoit un signal représentatif de la fréquence canal d'entrée, est agencée pour maintenir la fréquence Fh de l'oscillateur local 40 au-dessus de la fréquence d'accord Fs du filtre 31 lorsque la fréquence canal d'entrée se situe dans une partie inférieure de la bande de réception. L'unité de gestion établit alors un battement de fréquence dit inférieur correspond à FI= Fh-Fs. La partie inférieure de la bande de réception correspond aux fréquences basses de la bande de réception. L'unité de gestion est aussi agencée pour maintenir la fréquence Fh au-dessous de la fréquence Fs lorsque la fréquence canal d'entrée se situe dans une partie supérieure de la bande de réception. L'unité de gestion établit alors un battement de fréquence dit supérieur correspond à FI=Fs-Fh. La partie supérieure de la bande de réception correspond aux fréquences hautes de la bande de réception et peut éventuellement chevaucher la partie inférieure de la bande de réception. Les battements inférieur et supérieur correspondent toujours à la même fréquence intermédiaire fixe.

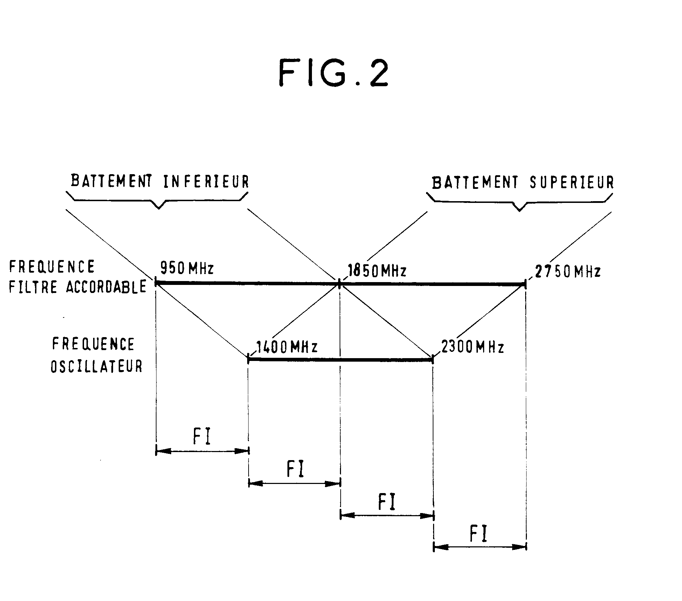

Comme visible sur la figure 2, la fréquence intermédiaire FI est choisie égale au quart de la largeur de la bande de réception de sorte que la bande balayée par l'oscillateur est moitié moins large que la bande de réception. Il en résulte que l'inversion du sens du battement peut avoir lieu au milieu de la bande de réception, la bande de réception étant alors balayée de façon continue sans coupure ni chevauchement. Ainsi pour une bande de réception située entre 950 et 2750 MHz, la fréquence intermédiaire FI est égale à 450 MHz, la fréquence correspondant à l'inversion du sens du battement est égale à 1850 MHz et la bande couverte par l'oscillateur se situe entre 1400 et 2300 MHz. Pour une bande de réception située entre 700 et 2750 MHz, la fréquence intermédiaire FI est égale à 512,5 MHz, la fréquence correspondant à l'inversion du sens du battement est égale à 1750 MHz et la bande couverte par l'oscillateur se situe entre 1212,5 et 2237,5 MHz.

Nous allons maintenant présenter un mode de réalisation du récepteur selon l'invention dans lequel l'inversion du sens du battement se fait de façon automatique et dans le cas d'une bande de réception se situant entre 950 et 2750 MHz, avec une fréquence intermédiaire de 450 MHz. On pourra appliquer directement la construction décrite à la bande de réception située entre 700 et 2750 MHz en adaptant seulement la fréquence correspondant à l'inversion du sens du battement.

A cet effet, l'oscillateur local 40 et le filtre accordable 31 peuvent être commandés en synchronisme par une tension de commande fournie par un synthétiseur, connu en soi, qui fait partie de l'unité de gestion 41. La tension fournie par le synthétiseur peut varier entre 0 et 12 volts. Cette tension de commande est directement appliquée à l'entrée de commande de l'oscillateur local 40 qui balaie, en réponse à la tension de commande, la bande de fréquence située entre 1400 et 2300 MHz. Il faut comprendre qu'en réponse à une tension de 0 volt, il engendre une fréquence de 1400 MHz et qu'en réponse à une tension de 12 volts, il engendre une fréquence de 2300 MHz. Par ailleurs cette tension de commande est appliquée en entrée d'un moyen adaptateur de tension 39. Ce moyen adaptateur dérive de la tension de commande, une seconde tension de commande qui est appliquée à l'entrée de commande du filtre accordable 31. En réponse à cette seconde tension de commande, il balaie la bande de réception se situant entre 950 et 2750 MHz. Dans le cas d'exemple, la seconde tension de commande varie entre 0 et 24 volts de la façon suivante. L'unité de gestion 41, classiquement utilisée pour les téléviseurs conventionnels et comprenant un microprocesseur, est apte à recevoir un signal FC représentatif d'une fréquence canal d'entrée située dans la bande de réception, à comparer cette fréquence canal à une fréquence d'inversion du sens du battement de fréquence, et à fournir un signal à deux états représentatif du résultat de la comparaison. En particulier un premier état du signal de comparaison correspond à une fréquence canal inférieure à 1850 MHz et un second état correspond à une fréquence canal supérieure ou égale à 1850 MHz. L'unité de gestion 41 engendre, après comparaison de la fréquence canal reçue avec la fréquence de 1850 MHz, le signal de comparaison qui se trouve dans l'un des deux états et la tension de commande allant de 0 à 12 volts. L'unité de gestion, à travers le synthétiseur, est agencée pour engendrer cette tension de commande de manière telle que le niveau de celle-ci varie linéai- rement entre 0 et 12 volts lorsque la fréquence canal varie entre 950 et 1850 MHz ou lorsque la fréquence canal varie entre 1850 et 2750 MHz. On comprendra donc que le niveau de la tension de commande varie de façon identique entre 0 et 12 volts pour le balayage de la partie inférieure de la bande de réception (fréquence canal inférieure à 1850 MHz) ou pour le balayage de la partie supérieure de la bande de réception.

Le moyen adaptateur de tension 39, qui est un additionneur de tension, est commandé par le signal de comparaison et reçoit la tension de commande fournie par le synthétiseur et une tension supplémentaire V. Lorsque le signal de comparaison se trouve dans le premier état, il restitue en sortie une seconde tension de commande identique à la tension de commande qu'il reçoit. Dans ce cas, le niveau de la seconde tension de commande varie entre 0 et 12 volts. Lorsque le signal de comparaison se trouve dans le second état, il restitue en sortie une seconde tension de commande correspondant à la tension de commande qu'il reçoit augmentée de la tension supplémentaire V. Cette tension supplémentaire est de 12 volts et force le filtre accordable 31 à balayer la sous-bande située entre 1850 et 2750 MHz alors que l'oscillateur balaie la bande située entre 1400 et 2300 MHz. Dans ce cas, le niveau de la seconde tension de commande varie entre 12 et 24 volts. Ainsi, lorsque la fréquence canal choisie est inférieure à 1850 MHz, l'unité de gestion asservit l'oscillateur local 40 et le filtre passe-bande 31 pour établir le battement inférieur de fréquence entre la fréquence de l'oscillateur et la fréquence d'accord du filtre. Lorsque la fréquence canal est supérieure ou égale à 1850 MHz, l'unité de gestion asservit l'oscillateur local 40 et le filtre passe-bande 31 pour établir le battement supérieur de fréquence entre la fréquence de l'oscillateur et la fréquence d'accord du filtre. Selon cette construction, l'oscillateur local balaie deux fois la même bande de fréquence alors que le filtre accordable balaie un seule fois la bande de réception.

Pour une fréquence intermédiaire non égale au quart de la largeur de la bande de réception, la construction précédemment décrite devra être aménagée et en particulier l'unité de gestion devra engendrer une tension de commande s'inscrivant dans des plages différentes de tension selon que la fréquence canal est inférieure ou supérieure à la fréquence choisie pour l'inversion du sens du battement ce qui complique le fonctionnement de l'unité de gestion 41.

Les signaux de mélange fournis par le mélangeur 32 sont ensuite filtrés dans l'étage de filtrage 5 qui comprend de façon classique un amplificateur 33 à commande automatique de gain relié en sortie à un filtre sélectif 34 laissant passer les signaux de mélange à la fréquence intermédiaire FI. La sortie du filtre 34 est reliée à l'entrée d'un démodulateur 35, par exemple à boucle à verrouillage de phase, constituant l'étage de démodulation 6 qui produit des signaux en bande de base. La sortie du démodulateur 35 est relié à un couple d'amplificateurs 36,37 montés en parallèle, dont l'un 37 est un inverseur de spectre. Les sortie des amplificateurs 36,37 sont fournies à un commutateur 38 qui sélectionne, en réponse au signal de comparaison, l'une des sorties des amplificateurs 36 ou 37 pour maintenir constante la polarité des signaux bande de base fourni par le démodulateur quel que soit le sens du battement de fréquence. En particulier, pour le battement dit supérieur, le commutateur sélectionne la sortie de l'amplificateur inverseur 37.

Bien entendu, l'invention n'est pas limitée à l'exemple de réalisation ci-dessus décrit, et on pourra prévoir d'autres variantes, sans pour cela sortir du cadre de l'invention.

## Revendications

1.) Un récepteur superhétérodyne large bande à fréquence intermédiaire fixe, notamment pour installation de réception de signaux transmis par satellite, caractérisé en ce qu'il comprend:
- un filtre passe-bande (31) accordable dans la totalité d'une bande de réception de largeur L;
- un oscillateur local (40) balayant une bande de fréquences de largeur inférieure à la largeur L de la bande réception et centrée par rapport à celle-ci;
- un moyen de commande (41) asservissant le filtre passe-bande et l'oscillateur local pour établir un battement de fréquences entre la fréquence d'accord du filtre passe-bande et la fréquence de l'oscillateur local, ce battement correspondant à la fréquence intermédiaire fixe FI égale au quart de la largeur de la bande de réception, le moyen de commande étant en outre agencé pour maintenir, en fonction d'un signal de commande représentatif d'une fréquence canal d'entrée à recevoir, la fréquence de l'oscillateur local au-dessus de la fréquence d'accord du filtre quand cette fréquence canal se situe dans une partie inférieure de la bande de réception et pour maintenir la fréquence de l'oscillateur local au-dessous de la fréquence d'accord du filtre quand cette fréquence canal se situe dans une partie supérieure de la bande de réception.

2.) Le récepteur selon la revendication 1, dans lequel le moyen de commande est agencé pour inverser le sens du battement de fréquence au milieu de la bande de réception.

3.) Le récepteur selon l'une des revendications 1 ou 2, comprenant en outre un moyen adaptateur de tension (39), et dans lequel le moyen de commande (41) est agencé pour engendrer un signal de comparaison représentatif du sens du battement et une première tension de commande de l'oscillateur local (40) et du filtre accordable (31), l'oscillateur recevant directement cette première tension de commande et le filtre accordable recevant une seconde tension de commande fournie parle moyen adaptateur en réponse à ladite première tension de commande et au signal de comparaison.

4.) Le récepteur selon l'une quelconque des revendications précédentes, comprenant en outre un moyen (36,37) pour maintenir constante la polarité du signal fourni en sortie du récepteur quelque soit le sens du battement de fréquence.

5.) Le récepteur selon l'une quelconque des revendications précédentes, dans lequel la bande de réception se situe entre 950MHz et 2750MHz et la fréquence intermédiaire FI est égale à 450MHz.

6.) Le récepteur selon l'une quelconque des revendications précédentes, dans lequel la bande de réception se situe entre 700MHz et 2750MHz et la fréquence intermédiaire FI est égale à 512,5MHz.
